# EUROPÄISCHE PATENTSCHRIFT

(11) **EP 3 097 053 B1**
(45) Veröffentlichungstag und Bekanntmachung des Hinweises auf die Patenterteilung: **06.12.2017**
(21) Anmeldenummer: 15700394.8
(22) Anmeldetag: 16.01.2015
(51) Int. Cl.: C01B 33/035

(54) **VERFAHREN ZUR HERSTELLUNG VON POLYKRISTALLINEM SILICIUM**
METHOD FOR PRODUCING POLYCRYSTALLINE SILICON
PROCÉDÉ DE FABRICATION DE SILICIUM POLYCRISTALLIN

(30) Priorität: 22.01.2014 DE 102014201096
(43) Veröffentlichungstag der Anmeldung: 30.11.2016
(73) Patentinhaber: Wacker Chemie AG, 81737 München (DE)
(72) Erfinder: FAERBER, Stefan, 84577 Tüßling (DE); BERGMANN, Andreas, 84556 Kastl (DE); PECH, Reiner, 84524 Neuötting (DE); RIESS, Siegfried, A-5121 Tarsdorf (AT)
(74) Vertreter: Potten, Holger
(86) Internationale Anmeldenummer: PCT/EP2015/050769
(87) Internationale Veröffentlichungsnummer: WO 2015/110358

(56) Entgegenhaltungen:
- EP-A1- 1 886 971
- EP-A1- 2 479 142
- DE-A1-102011 089 449
- DATABASE WPI Week 201126 Thomson Scientific, London, GB; AN 2011-C89043 XP002737955, & WO 2011/033712 A1 (SHINETSU CHEM CO LTD) 24. März 2011 (2011-03-24)

## Beschreibung

Gegenstand der Erfindung ist ein Verfahren zur Herstellung von polykristallinem Silicium.

Polykristallines Silicium (kurz: Polysilicium) dient als Ausgangsmaterial bei der Herstellung von einkristallinem Silicium mittels Tiegelziehen (Czochralski- oder CZ-Verfahren)- oder mittels Zonenschmelzen (Floatzone oder FZ-Verfahren). Dieses einkristalline Silicium wird in Scheiben (Wafer) zertrennt und nach einer Vielzahl von mechanischen, chemischen und chemo-mechanischen Bearbeitungen in der Halbleiterindustrie zur Fertigung von elektronischen Bauelementen (Chips) verwendet.

Insbesondere wird aber polykristallines Silicium in verstärktem Maße zur Herstellung von ein- oder multikristallinem Silicium mittels Zieh- oder Gieß-Verfahren benötigt, wobei dieses ein- oder multikristalline Silicium zur Fertigung von Solarzellen für die Photovoltaik dient.

Das polykristalline Silicium wird üblicherweise mittels des Siemens-Prozesses hergestellt. Dabei werden in einem glockenförmigen Reaktor (dem sog. "Siemens-Reaktor") Dünnstäbe aus Silicium durch direkten Stromdurchgang auf Oberflächentemperaturen von 900-1200 °C erhitzt und ein Reaktionsgas enthaltend eine Silicium enthaltende Komponente, insbesondere ein Halogensilan, und Wasserstoff über Einlassdüsen eingeleitet. Dabei zersetzen sich die Halogensilane an der Oberfläche der Dünnstäbe. Dabei scheidet sich elementares Silicium aus der Gasphase auf den Dünnstäben ab.

Die Siliciumstäbe werden dabei im Reaktor von speziellen Elektroden gehalten, die in der Regel aus hochreinem Elektrographit bestehen. Jeweils zwei Dünnstäbe mit unterschiedlicher Spannungspolung an den Elektrodenhalterungen sind am anderen Dünnstabende mit einer Brücke zu einem geschlossenen Stromkreis verbunden. Über die Elektroden und deren Elektrodenhalterungen wird elektrische Energie zur Beheizung der Dünnstäbe zugeführt.

Während der Abscheidung wächst der Durchmesser der Dünnstäbe. Gleichzeitig wächst die Elektrode, beginnend an ihrer Spitze, in den Stabfuß der Siliciumstäbe ein.

Als Werkstoff für die Elektroden wird hauptsächlich Graphit verwendet, da Graphit in sehr hoher Reinheit zur Verfügung steht und bei Abscheidebedingungen chemisch inert ist. Weiterhin hat Graphit einen sehr geringen spezifischen elektrischen Widerstand.

Nach dem Erreichen eines gewünschten Solldurchmessers der Siliciumstäbe wird der Abscheideprozess beendet, die glühenden Siliciumstäbe abgekühlt und ausgebaut.

Anschließend werden die erhaltenen, U-förmigen Stabpaare aus Polysilicium üblicherweise elektroden- und brückenseitig abgelängt und zu Bruchstücken zerkleinert. Die Zerkleinerung erfolgt mittels eines Brechers, z.B. mit einem Backenbrecher. Ein solcher Brecher ist beispielsweise beschrieben in EP 1 338 682 A2. Gegebenenfalls erfolgt zuvor eine Vorzerkleinerung mittels eines Hammers.

Zuvor wird üblicherweise die Graphitelektrode entfernt. EP 2 479 142 A1 offenbart, mindestens 70 mm vom elektrodenseitigen Ende des Stabs zu entfernen. Dies soll zu einer geringeren Konzentration an Fremdstoffen wie Chrom, Eisen, Nickel, Kupfer und Kobalt im Inneren der erzeugten Siliciumbruchstücke führen. Die Entfernung erfolgt durch ein Schneidwerkzeug, z.B. mittels einer Rotationssäge. Allerdings geht bei diesem Verfahren eine nicht unerhebliche Menge an polykristallinem Silicium verloren.

Jedoch sind auch Verfahren bekannt, bei denen das abgetrennte Ende des Stabs, das Silicium und Graphit enthält, chemisch behandelt wird, indem der Graphit abgeätzt oder in eine Pulverform überführt wird, der leicht vom Polysilicium getrennt werden kann. Dabei ergibt sich ein Stabstück, das von Graphit befreit ist und weiterverarbeitet werden kann. Allerdings besteht die Gefahr, das polykristalline Silicium dabei zu kontaminieren. Solche Verfahren sind beschrieben in CN 101691222 B, CN 101974784 A, CN 102121106 A und CN 102211773 A.

In CN202358922 U wird versucht, durch eine geeignete Konstruktion von Elektrode und Elektrodenhalterung ein Hineinwachsen der Elektrode in den Stabfuß zu vermeiden. Dies soll zu einer höheren Ausbeute an polykristallinem Silicium führen.

Es besteht also die Aufgabe, die Elektrode vollständig zu entfernen und dabei eine möglichst geringe Kontamination des polykristallinen Siliciums zu erreichen. Zudem soll das Verfahren eine hohe Produktivität und eine maximale Ausbeute an polykristallinem Silicium sicherstellen.

Die Aufgabe wird gelöst durch ein Verfahren zur Herstellung von polykristallinem Silcium, umfassend
a) Abscheidung von polykristallinem Silicium mittels CVD auf wenigstens einem U-förmigenTrägerkörper, der durch direkten Stromdurchgang auf eine Temperatur aufgeheizt wird, bei der sich polykristallines Silicium auf dem Trägerkörper abscheidet, wodurch wenigstens ein U-förmiges polykristallines Siliciumstabpaar entsteht, wobei der Trägerkörper an seinen freien Enden jeweils mit einer Graphitelektrode verbunden ist und auf diese Weise mit Strom versorgt wird;
b) Ausbau des wenigstens einen polykristallinen Siliciumstabpaares aus dem Reaktor
c) Entfernen von Graphitresten von den elektrodenseitigen Enden der wenigstens zwei polykristallinen Siliciumstäbe des wenigstens einen polykristallinen Siliciumstabpaares;
d) Zerkleinerung der wenigstens zwei polykristallinen Siliciumstäbe zu Stabstücken oder zu Bruchstücken;
dadurch gekennzeichnet, dass die Graphitreste von den elektrodenseitigen Enden der wenigstens zwei polykristallinen Siliciumstäbe jeweils mittels wenigstens eines mechanischen Impulses abgeschlagen werden.

Bevorzugte Ausführungsformen des Verfahren sind den abhängigen Ansprüchen zu entnehmen.

Die Abscheidung erfolgt wie in der Beschreibung des Stands der Technik erläutert. Der Ausbau der Stabpaare kann mittels eines Kranes, eines Greifers oder dergleichen erfolgen.

Die Siliciumstäbe werden zu Stabstücken oder Bruchstücken zerkleinert.

Bei der Zerkleinerung zu Stabstücken können nach Entfernung der Graphitreste von den elektrodenseitigen Enden der Stäbe ein oder mehrere Stabstücke von einem oder von beiden Enden der Stäben abgetrennt werden.

Besonders bevorzugt ist es, die Siliciumstäbe zu Bruchstücken zu zerkleinern.
Die Zerkleinerung der Siliciumstäbe zu Bruchstücken erfolgt vorzugweise mittels eines Backen- oder Walzenbrechers. Gegenfalls erfolgt zuvor eine Vorzerkleinerung mittels geeigneter Schlagwerkzeuge.

Das Abschlagen der Graphitreste erfolgt vorzugsweise mit einem Schlagwerkzeug, besonders bevorzugt mit einem Hammer. Die Schlagfläche des Schlagwerkzeugs, z.B. der Hammerkopf, umfasst ein kontaminationsarmes Hartmetall oder eine abriebsarme Keramik wie Wolframcarbid, Titancarbid, Chromcarbid, Molybdäncarbid, Vanadiumcarbid, Nickelcarbid oder Siliciumcarbid.

Die bei dem wenigstens einen mechanischen Impuls aufgewendete Schlagenergie beträgt vorzugweise höchstens 20 J, besonders bevorzugt höchstens 10 J. Vorzugsweise wird die Schlagenergie mittels geeigneter Drucksensoren bestimmt. Ebenso ist es möglich, die Schlagenergie aus Geschwindigekit und Masse des Schlagwerkzeugs zu berechnen, wobei die Endgeschwindigkeit des Schlagwerkzeugs z.B. mittels einer Kamera bestimmt wird.

Nach dem Abschlagen der Graphitreste weisen die Siliciumstäbe vorzugsweise eine Oberflächenkontamination mit Fe, Cr, Ni, W, Ti und Co in Summe von weniger als 250 pptw auf.

Die Bestimmung der Oberflächenmetalle erfolgt nach ASTM F 1724-96 durch chemisches Ablösen der Silicium-Oberfläche und anschließender Analyse der abgelösten Lösung mittels ICPMS (inductively-coupled-plasma mass-spectrometry).

Vorzugweise erfolgt der mechanische Impuls in einem Abstand von höchstens 50 mm vom elektrodenseitigen Ende des Siliciumstabs. Besonders bevorzugt ist ein Abstand von höchstens 20 mm, ganz besonders bevorzugt höchstens 10 mm. Der Abstand sollte mindestens 5 mm betragen.

Vorzugweise erfolgt das Abschlagen der Graphitreste in einem Reinraum.

Während des Abschlagens der Graphitreste ist der Reststab (Abstand vom elektrodenseitigen Ende größer als 50 mm falls mechanischer Impuls bei kleiner als 50 mm Abstand erfolgt) mit einem Kunststoffsack überzogen. In dieser Konstellation werden besonders gute Ergebnisse hinsichtlich der Kontamination der Stäbe erzielt. Vorzugweise beträgt die Kontamination der Siliciumstäbe mit Oberflächenmetallen Fe, Cr und Ni in Summe höchstens 30 pptw, besonders bevorzugt höchstens 10 pptw.

Vorzugweise erfolgt das Abschlagen der Graphitreste mittels zweier mechanischer Impulse.

Die bei dem ersten mechanischen Impuls aufgewendete Schlagenergie beträgt vorzugweise höchstens 20 J und erfolgt in einem Abstand von höchstens 30 mm vom elektrodenseitigen Ende des Siliciumstabs.

Die bei dem zweiten mechanischen Impuls aufgewendete Schlagenergie beträgt vorzugweise höchstens 10 J und erfolgt in einem Abstand von höchstens 30 mm vom elektrodenseitigen Ende des Siliciumstabs.

Alternativ können statt dem ersten mechanischen Impuls mehrere Schläge mit einer Schlagenergie von jeweils etwa 2 J erfolgen.

Alternativ können statt dem zweiten mechanischen Impuls mehrere Schläge mit einer Schlagenergie von jeweils etwa 1 J erfolgen.

Vorzugweise erfolgt das Abschlagen der Graphitreste in räumlicher Trennung von den nachfolgenden Prozessschritten, insbesondere vom der Zerkleinerung der Stäbe zu Bruchstücken. Dies kann auch dadurch bewerkstelligt werden, dass der Arbeitsplatz, an dem das Abschlagen der Graphitreste erfolgt, abgeschottet wird, beispielsweise durch geeignete Wandelemente oder Vorhänge.

Vorzugweise erfolgen die mechanischen Impulse zum Abschlagen der Graphitreste in einem Winkel von kleiner als 45° zur Stabachse, wobei die Stabachse horizontal angeordnet ist. Es hat sich gezeigt, dass dadurch ein gezielteres Abtrennen der Graphitreste bei niedriger Komtamination ermöglicht wird. Für das Personal bedeutet es zudem erhöhte Sicherheit, wenn der Stab definiert bricht.

Besonders bevorzugt liegt der Stab auf einer geeigneten Auflage, wobei sich ein Auflagepunkt in einem Abstand von weniger als 500 mm, besonders bevorzugt weniger als 300 mm, ganz besonders bevorzugt weniger als100 mm vom elektrodenseitigen Ende des Stabs befindet.

Vorzugweise erfolgt das Abschlagen der Graphitreste, während sich das wenigstens einen Siliciumstabpaar in einer Ausbauhilfe befindet. Eine Ausbauhilfe umfasst einen Körper mit einer Außenwand und einer Innenwand, von dem das Stabpaar vollständig umschlossen wird, wobei der Körper mitsamt dem von ihm umschlossenen Stabpaar mittels eines Kranes, eines Seilzuges oder eines Greifers aus dem Reaktor entfernt wird.

Der Körper ist vorzugsweise so dimensioniert, dass seine Länge mindestens der Höhe des stehenden Stabpaares entspricht. Seine Breite beträgt vorzugsweise mindestens der Breite eines U-förmigen Siliciumstabpaares (Siliciumbrücke + Stabdurchmesser). Vorzugsweise beträgt seine Breite mindestens 200 mm, besonders bevorzugt mindestens 300 mm.

Vorzugsweise weist der Körper eine Innenwand aus Stahl auf. Die Innenwand der Körpers kann mit einem Polymer beschichtet sein. Vorzugweise besteht der Körper aus Stahl, weist also einen Stahlmantel auf. Besonders bevorzugt ist eine Ausführung, die einen Körper mit einer nicht beschichteten Stahlinnenwand vorsieht, wobei das Siliciumstabpaar während des Ausbaus mit einem Kunststoffsack überzogen ist. Alternativ zur nicht beschichteten Stahlwand in Kombination mit einem Kunststoffsack ist insbesondere auch eine Ausführungsform des Körpers aus einem kontaminationsarmen Hartmetall oder einer abriebsarmen Keramik (z.B. Wolframcarbid, Titancarbid, Chromcarbid, Molybdäncarbid, Vanadiumcarbid und Nickelcarbid, Siliciumcarbid) bevorzugt.

Bevorzugt ist auch die Verwendung eines Körpers enthaltend eine Stahlinnenwand, wobei die Innenwand des Körpers mit einem solchen kontaminationsarmen Hartmetall oder mit einer abriebsarmen Keramik teilweise oder vollflächig beschichtet ist.

Ebenso ist es bevorzugt, dass der Körper aus einem flexiblen, aber stabilen Kunststoff besteht. Als mögliche Kunststoffe bieten sich hierbei Faserverbundkunststoff, aus einem aromatischen Polyamid (Aramidfasern) oder aus einem Polyester wie Polycarbonat und Polyethylenterephthalat an. Genauso sind Materialien aus Carbon oder Carbon-Bestandteilen oder Glasfaserverstärkte Kunststoffe (GFK) möglich.

Das Herausheben des Siliciumstabpaares selbst kann erfolgen mit Hilfe einer Kranvorrichtung, einem Seilzug oder vergleichbaren Systemen.

Vorzugsweise umfasst der Körper jeweils eine händisch oder mittels eines mechanischen oder elektrischen Mechanismus schließbare Klappe an einer oder mehreren Öffnungen des Körpers. Nach dem Herausheben der Stäbe aus dem Reaktor kann das Abschlagen der Graphitreste erfolgen, während sich das Stabpaar noch im Körper befindet. Zu diesem Zweck wird das Stabpaar beispielsweise mittels eines Greifers aus der Ausbauhilfe gehoben, so dass jeder Stabfuß weniger als 500 mm, besonders bevorzugt weniger als 300 mm und ganz besonders bevorzugt weniger als 100 mm aus der Öffnung der Ausbauhilfe herausragt. In dieser Konstellation erfolgt dann das Abschlagen der Graphitreste von den Stäben, wobei zumindest die nicht aus der Öffnung der Ausbauhilfe herausragenden Teile der Stäbe von einem Kunststoffsack überzogen sind.

Dabei wird vorzugweise sichergestellt, dass es zu keinem Kontakt zwischen Kunststoffsack und Graphitresten kommt. Der Kunststoffsack endet daher vorzugweise in einem Abstand von mindestens 5 mm von den Graphitresten. So kann vermieden werden, dass der Kunststoffsack von den Graphitresten kontaminiert wird.

Vorzugweise kommt ein Wagen zum Einsatz, der an die Ausbauhilfe herangefahren werden kann. Der Wagen ist vorzugweise so gestaltet, dass er unterhalb der elektrodenseitigen Ende der Stäbe platziert werden kann, während sich die Stäbe noch in der Ausbauhilfe befinden.. Der Wagen ist vorzugwesie mit einem kontaminationsarmen Material wie Silicium oder Kunststoff ausgekleidet. Vorzugweise umfasst der Wagen eine Auffangbox für abgeschlagenes Material. Ganz besonders bevorzugt umfasst der Wagen eine Trennplatte, z.B. ein Gitter oder ein Sieb, unterhalb der elektrodenseitigen Enden der Siliciumstäbe. Größere Brocken werden dabei von der Trennplatte aufgefangen, während kleinere Brocken durch die Trennplatte fallen und in der Auffangbox landen. Dies ermöglicht es, die größeren Brocken hinsichtlich vorhandener Graphitreste visuell zu klassifizieren.

Vorzugweise wird nach dem Ausbau der polykristallinen Siliciumstäbe aus dem Reaktor und vor dem Zerkleinern der ausgebauten polykristallinen Siliciumstäbe in Bruchstücke das in Stabform vorliegende polykristalline Silicium anhand wenigstens eines Merkmals in wenigstens zwei Qualitätsklassen klassifiziert, wobei jene wenigstens zwei Qualitätsklassen separaten Weiterverarbeitungsschritten zugeführt werden.

Die Erfindung sieht also vor, an den ausgebauten Siliciumstäben eine Klassifizierung in wenigstens zwei Qualitätsklassen vorzunehmen. Diese Klassifizierung erfolgt vor der Zerkleinerung der Stäbe in Bruchstücke. Sie erfolgt vorzugweise nach dem Abschlagen der Graphitelektrode. Es ist aber auch bevorzugt, eine Klassifizierung nach der Zerkleinerung der Stäbe in Bruchstücke vorzunehmen.

Beim Klassifikationsmerkmal kann es sich um das Merkmal "Kontamination der Oberfläche oder des Volumens" handeln.

Dabei kann nach oberflächlicher Kontamination der Stäbe oder Bruchstücke mit Metallen, Nichtmetallen oder Zusammensetzungen, nach Kontamination des Volumens der Stäbe oder Bruchstücke mit Metallen, Nichtmetallen oder Zusammensetzungen sowie nach Kontamination der Oberfläche der Stäbe oder Bruchstücke mit Staub (z.B. Silicium-Staub) oder nach Kombinationen der genannten Merkmale klassifiziert werden.

Beim Klassifikationsmerkmal kann es sich um ein optisch erkennbares Merkmal handeln.

Vorzugweise erfolgt eine Klassifizierung hinsichtlich des Vorhandenseins von Graphitresten an den Stäben. Stäbe mit Graphitresten werden vorzugweise in einer anderen Transporteinheit zur Weiterverarbeitung transportiert als die Stäbe ohne Graphitreste. Dies vermindert die Verschleppungsgefahr hinsichtlich Graphitresten.

Es ist auch bevorzugt, eine Klassifizierung nach der Zerkleinerung der Stäbe in Bruchstücke vorzunehmen. Insbesondere ist es bevorzugt,nach dem Merkmal "Abstand vom elektrodenseitigen Ende des Stabes" zu klassifizieren. Besonders bevorzugt werden Bruchstücke in wenigstens zwei Fraktionen klassifiziert, die nach einem solchen Merkmal unterscheidbar sind. In der Praxis lässt sich dies dadurch bewerkstelligen, dass aus einem Stab wenigstens zwei Stabstücke erzeugt werden, wobei ein Stabstück das Merkmal "Abstand von Elektrode < 1000 mm" und das andere Stabstück das Merkmal "Abstand von Elektrode > 1000 mm" aufweist. Die beiden Stabstücke werden separat zerkleinert, so dass die separat erzeugten Bruchstücke ebenfalls nach diesem Merkmal klassifiziert sind. Die wenigstens zwei Stabstücke und die daraus erzeugten wenigstens zwei Fraktionen an Bruchstücken können eine unterschiedliche Kontamination mit Fremdstoffen aufweisen. Sie können unterschiedlichen Weiterverarbeitungsschritten zugeführt werden.

### Vergleichsbeispiel

Im Vergleichsbeispiel erfolgte das in EP 2 479 142 A1 beschriebene Verfahren. Es wurden 70 mm vom elektrodenseitigen Ende des Stabs abgesägt. Bezogen auf das komplette Stabpaar ergab sich dabei eine Ausbeute von etwa 80%. Die Kontamination der Sägefläche mit Fe, Cr, Ni, W und Co betrug in Summe 1,3 ppm . Dies macht eine Reinigung der Staboberfläche nötig, bevor der Stab zu Bruchstücken zerkleinert werden kann.

### Beispiel

Im Beispiel erfolgte ein Abschlagen der Graphitreste mittels des erfindungsgemäßen Verfahrens. Es erfolgte jeweils ein mechanischer Impuls mit einem Hammer, wobei die aufgewendete Schlagenergie variiert wurde (10 J, 5 J, 3 J, 2 J, 1 J) und der Abstand vom elektrodenseitigen Ende des Stabs jeweils 50 mm betrug.

Die Kontamination mit Fe, Cr, Ni, W und Co an der Oberfläche ist deutlich niedriger als im Vergleichsbeispiel. Die Ausbeuten erhöhen sich. Eine Reinigung der Stäbe ist nicht nötig.

**Tabelle 1** zeigt eine Zusammenfassung der Ergebnisse.

**Tabelle 1**

| | Ausbeute | Kontamination an Oberfläche | Präsenz Graphit beim Zerkleinern | Reinigung nötig |
|---|---|---|---|---|
| Vergleichsbeispiel | < 85% | 1,3 ppm | niedrig | ja |
| Mechanischer Impuls 10J | > 85% | 200 pptw | niedrig | optional |
| Mechanischer Impuls 5J | > 90% | 105 pptw | niedrig | nein |
| Mechanischer Impuls 3J | > 95% | 81 pptw | Niedrig; mit Trennplatte: sehr niedrig | nein |
| Mechanischer Impuls 2J | > 98% | 56 pptw | Sehr niedrig; mit Trennplatte: 0 | nein |
| Mechanischer Impuls 1J | > 99% | 20 pptw | 0 | nein |

## Patentansprüche

1. Verfahren zur Herstellung von polykristallinem Silcium, umfassend
a) Abscheidung von polykristallinem Silicium mittels CVD auf wenigstens einem U-förmigenTrägerkörper, der durch direkten Stromdurchgang auf eine Temperatur aufgeheizt wird, bei der sich polykristallines Silicium auf dem Trägerkörper abscheidet, wodurch wenigstens ein U-förmiges polykristallines Siliciumstabpaar entsteht, wobei der Trägerkörper an seinen freien Enden jeweils mit einer Graphitelektrode verbunden ist und auf diese Weise mit Strom versorgt wird;
b) Ausbau des wenigstens einen polykristallinen Siliciumstabpaares aus dem Reaktor
c) Entfernen von Graphitresten von den elektrodenseitigen Enden der wenigstens zwei polykristallinen Siliciumstäbe des wenigstens einen polykristallinen Siliciumstabpaares;
d) Zerkleinerung der wenigstens zwei polykristallinen Siliciumstäbe zu Stabstücken oder zu Bruchstücken;
**dadurch gekennzeichnet, dass** die Graphitreste von den elektrodenseitigen Enden der wenigstens zwei polykristallinen Siliciumstäbe jeweils mittels wenigstens eines mechanischen Impulses abgeschlagen werden.

2. Verfahren nach Anspruch 1, wobei eine bei dem wenigstens einen mechanischen Impuls aufgewendete Schlagenergie höchstens 20 J beträgt.

3. Verfahren nach Anspruch 1 oder nach Anspruch 2, wobei der wenigstens eine mechanische Impuls jeweils in einem Abstand von höchstens 50 mm von jedem der elektrodenseitigen Enden der polykristallinen Siliciumstäbe erfolgt.

4. Verfahren nach einem der Ansprüche 1 bis 3, wobei das Abschlagen der Graphitreste mittels zweier mechanischer Impulse erfolgt, wobei eine bei dem ersten mechanischen Impuls aufgewendete Schlagenergie höchstens 20 J beträgt und jeweils in einem Abstand von höchstens 30 mm von jedem der elektrodenseitigen Enden der polykristallinen Siliciumstäbe erfolgt und wobei eine bei dem zweiten mechanischen Impuls aufgewendete Schlagenergie höchstens 10J beträgt und in einem Abstand von höchstens 30 mm von jedem der elektrodenseitigen Enden der polykristallinen Siliciumstäbe erfolgt.

5. Verfahren nach einem der Ansprüche 1 bis 4, wobei die mechanischen Impulse zum Abschlagen der Graphitreste jeweils in einem Winkel von kleiner als 45° zur Stabachse der polykristallinen Siliciumstäbe, wobei die Stabachse horizontal angeordnet ist, erfolgen.

6. Verfahren nach einem der Ansprüche 1 bis 5, wobei der Ausbau des wenigstens einen polykristallinen Siliciumstabpaares aus dem Reaktor mittels eines Körpers mit einer Außenwand und einer Innenwand erfolgt, von dem das Paar von polykristallinen Silicumstäben vollständig umschlossen wird, wobei der Körper mitsamt dem von ihm umschlossenen Paar von polykristallinen Silicumstäben mittels eines Kranes, eines Seilzuges oder eines Greifers aus dem Reaktor entfernt wird, wobei die elektrodenseitigen Enden der polykristallinen Silicumstäbe keinen Kontakt zur Innenwand haben.

7. Verfahren nach Anspruch 6, wobei der Körper eine Öffnung aufweist, durch die das wenigstens eine polykristalline Siliciumstabpaar nach der Entfernung aus dem Reaktor aus dem Körper herausragt oder gehoben wird, so dass jeder polykristalline Siliciumstab des Paares von polykristallinen Silicumstäben um höchstens 500 mm seiner Länge aus der Öffnung des Körpers herausragt, wobei anschließend die Graphitreste von den elektrodenseitigen Enden der wenigstens zwei polykristallinen Siliciumstäbe entfernt werden.

8. Verfahren nach einem der Ansprüche 1 bis 7, wobei die polykristallinen Siliciumstäbe während des Entfernens der Graphitreste von den elektrodenseitigen Enden der polykristallinen Silicumstäbe zumindest teilweise von einem Kunststoffsack überzogen sind.

9. Verfahren nach Anspruch 8, wobei die polykristallinen Siliciumstäbe jeweils bis zu einem Abstand von mindestens 5 mm von den elektrodenseitigen Enden der polykristallinen Silicumstäbe mit einem Kunststoffsack überzogen sind.

## Claims

1. Process for producing polycrystalline silicon, comprising
a) depositing polycrystalline silicon by means of CVD on at least one U-shaped support body which is heated by direct passage of current to a temperature at which polycrystalline silicon is deposited on the support body, resulting in formation of at least one U-shaped pair of polycrystalline silicon rods, each free end of the support body being connected to a graphite electrode and being supplied with power in this way;
b) deinstalling the at least one pair of polycrystalline silicon rods from the reactor;
c) removing graphite residues from the electrode ends of the at least two polycrystalline silicon rods of the at least one pair of polycrystalline silicon rods;
d) comminuting the at least two polycrystalline silicon rods to give rod pieces or to give chunks;
**characterized in that** the graphite residues are knocked off the electrode ends of each of the at least two polycrystalline silicon rods by means of at least one mechanical impulse.

2. Process according to Claim 1, wherein an impact energy expended in the at least one mechanical impulse is not more than 20 J.

3. Process according to Claim 1 or according to Claim 2, wherein in each case the at least one mechanical impulse is exerted at a distance of not more than 50 mm from each of the electrode ends of the polycrystalline silicon rods.

4. Process according to any of Claims 1 to 3, wherein the graphite residues are knocked off by means of two mechanical impulses, wherein an impact energy expended in the first mechanical impulse is not more than 20 J and in each case is made at a distance of not more than 30 mm from each of the electrode ends of the polycrystalline silicon rods, and wherein an impact energy expended in the second mechanical impulse is not more than 10 J and is made at a distance of not more than 30 mm from each of the electrode ends of the polycrystalline silicon rods.

5. Process according to any of Claims 1 to 4, wherein the mechanical impulses to knock off the graphite residues are each made at an angle of less than 45° to the rod axis of the polycrystalline silicon rods, with the rod axis arranged horizontally.

6. Process according to any of Claims 1 to 5, wherein the at least one pair of polycrystalline silicon rods is deinstalled from the reactor by means of a body which has an outer wall and an inner wall and fully surrounds the pair of polycrystalline silicon rods, wherein the body along with the pair of polycrystalline silicon rods that it surrounds is removed from the reactor by means of a crane, a cable winch or a grab, wherein the electrode ends of the polycrystalline silicon rods have no contact with the inner wall.

7. Process according to Claim 6, wherein the body has an opening through which the at least one pair of polycrystalline silicon rods projects from or is raised out of the body after removal from the reactor, such that each polycrystalline silicon rod of the pair of polycrystalline silicon rods projects out of the opening of the body for not more than 500 mm of its length, wherein the graphite residues are then removed from the electrode ends of the at least two polycrystalline silicon rods.

8. Process according to any of Claims 1 to 7, wherein the polycrystalline silicon rods are covered at least partly by a plastic bag during the removal of the graphite residues from the electrode ends of the polycrystalline silicon rods.

9. Process according to Claim 8, wherein the polycrystalline silicon rods are each covered by a plastic bag up to a distance of at least 5 mm from the electrode ends of the polycrystalline silicon rods.

## Revendications

1. Procédé de fabrication de silicium polycristallin, comprenant :
a) le dépôt de silicium polycristallin par dépôt chimique en phase vapeur (CVD) sur au moins un corps support en forme de U, qui est porté par passage de courant direct à une température à laquelle du silicium polycristallin se dépose sur le corps support, au moins une paire de baguettes de silicium polycristallin en forme de U étant ainsi formée, le corps support étant relié à chacune de ses extrémités libres avec une électrode en graphite et ainsi alimenté en courant ;
b) le démontage de ladite au moins une paire de baguettes de silicium polycristallin du réacteur,
c) l'élimination de résidus de graphite des extrémités du côté des électrodes desdites au moins deux baguettes de silicium polycristallin de ladite au moins une paire de baguettes de silicium polycristallin ;
d) le broyage desdites au moins deux baguettes de silicium polycristallin en tronçons ou en fragments ;
**caractérisé en ce que** les résidus de graphite sont décollés des extrémités du côté des électrodes desdites au moins deux baguettes de silicium polycristallin à chaque fois au moyen d'au moins une impulsion mécanique.

2. Procédé selon la revendication 1, dans lequel une énergie de décollement appliquée lors de ladite au moins une impulsion mécanique est d'au plus 20 J.

3. Procédé selon la revendication 1 ou la revendication 2, dans lequel ladite au moins une impulsion mécanique a lieu à chaque fois à une distance d'au plus 50 mm de chacune des extrémités du côté des électrodes des baguettes de silicium polycristallin.

4. Procédé selon l'une quelconque des revendications 1 à 3, dans lequel le décollement des résidus de graphite a lieu au moyen de deux impulsions mécaniques, une énergie de décollement appliquée lors de la première impulsion mécanique étant d'au plus 20 J et ayant lieu à chaque fois à une distance d'au plus 30 mm de chacune des extrémités du côté des électrodes des baguettes de silicium polycristallin, et une énergie de décollement appliquée lors de la seconde impulsion mécanique étant d'au plus 10 J et ayant lieu à une distance d'au plus 30 mm de chacune des extrémités du côté des électrodes des baguettes de silicium polycristallin.

5. Procédé selon l'une quelconque des revendications 1 à 4, dans lequel les impulsions mécaniques pour le décollement des résidus de graphite ont lieu à chaque fois à un angle de moins de 45° par rapport à l'axe des baguettes de silicium polycristallin, l'axe des baguettes étant agencé à l'horizontale.

6. Procédé selon l'une quelconque des revendications 1 à 5, dans lequel le démontage de ladite au moins une paire de baguettes de silicium polycristallin du réacteur a lieu au moyen d'un corps comprenant une paroi extérieure et une paroi intérieure, par lequel la paire de baguettes de silicium polycristallin est entièrement entourée, le corps étant extrait du réacteur conjointement avec la paire de baguettes de silicium polycristallin qu'il entoure au moyen d'une grue, d'une traction par câble ou d'une benne preneuse, les extrémités du côté des électrodes des baguettes de silicium polycristallin n'étant pas en contact avec la paroi intérieure.

7. Procédé selon la revendication 6, dans lequel le corps comprend une ouverture par laquelle ladite au moins une paire de baguettes de silicium polycristallin dépasse ou est soulevée hors du corps après l'extraction du réacteur, de sorte que chaque baguette de silicium polycristallin de la paire de baguettes de silicium polycristallin dépasse d'au plus 500 mm de sa longueur par l'ouverture du corps, les résidus de graphite étant ensuite éliminés des extrémités du côté des électrodes desdites au moins deux baguettes de silicium polycristallin.

8. Procédé selon l'une quelconque des revendications 1 à 7, dans lequel les baguettes de silicium polycristallin sont au moins partiellement recouvertes par un sac en plastique pendant l'élimination des résidus de graphite des extrémités du côté des électrodes des baguettes de silicium polycristallin.

9. Procédé selon la revendication 8, dans lequel les baguettes de silicium polycristallin sont recouvertes avec un sac en plastique à chaque fois jusqu'à une distance d'au moins 5 mm des extrémités du côté des électrodes des baguettes de silicium polycristallin.
